# EUROPEAN PATENT APPLICATION

(11) **EP 4 349 623 A1**
(43) Date of publication of application: **10.04.2024**
(21) Application number: 22837333.8
(22) Date of filing: 10.05.2022
(51) Int. Cl.: B60H 1/00, H05K 7/20

(54) **VEHICLE AIR-CONDITIONING DEVICE**

(30) Priority: 05.07.2021 JP 2021111529
(71) Applicant: MITSUBISHI HEAVY INDUSTRIES THERMAL SYSTEMS, LTD., Tokyo 100-8332 (JP)
(72) Inventor: TAKEZAWA, Hideyuki, Tokyo 100-8332 (JP)
(74) Representative: Cabinet Beau de Loménie
(86) International application number: PCT/JP2022/019780
(87) International publication number: WO 2023/281912

(57) **Abstract**

Provided is a vehicular air conditioning device with which heat radiation efficiency can be increased without changing the height dimension of heat radiation fins. The device includes a casing including an air inlet and an air outlet, in which a flow path causing the air inlet and the air outlet to communicate with each other is formed; a fan housed in the casing and that generates a flow of air from the air inlet, through the flow path, to the air outlet; a heat generation portion provided outside the casing; and a heat radiation portion. The heat radiation portion is thermally connected to the heat generation portion and includes a base (31) having an installation surface (31a), and a plurality of plate-like fins (32). The plurality of fins are disposed in the flow path to extend along the direction of air flow and stand upright from the installation surface (31a) in a direction orthogonal to the direction of the flow. A plurality of ridges (33) are formed along the direction of the flow is provided over a standing direction of the fins (32) on the surfaces of the plurality of fins (32).

## Description

### Technical Field

The present disclosure relates to a vehicular air conditioning device.

### Background Art

In the field of heating ventilation and air conditioning (HVAC) units, such as described in Patent Document 1, a fan controller performs voltage control of a fan while radiating heat generated by a power element (MOS-FET, etc.) with a heat radiation fin.

### Citation List

### Patent Literature

Patent Document 1: JP 2020-179769 A

### Summary of Invention

### Technical Problem

In recent years, outside temperatures have been increasing and the environmental conditions under which a vehicular air conditioning device (HVAC) is used have been deteriorating. Thus, a fan controller is likely to be affected by the outside temperature, and there is a possibility that an existing heat radiation fin cannot sufficiently radiate heat of a power element.

Therefore, to improve heat radiation efficiency (heat radiation performance), a method of increasing the height, width, and length dimensions of a heat radiation fin may be used. However, since the size of a flow path in which the heat radiation fin is installed is predetermined depending on the specifications of the HVAC, it is not always possible to sufficiently increase the height, width, and length dimensions of the heat radiation fin. In addition, even when the height, width, and length dimensions are increased, pressure loss in the flow path increases accordingly, and thus this method cannot be said to be effective from the viewpoint of flow path resistance.

The present disclosure has been made in view of such circumstances, and it is an object of the present disclosure to provide a vehicular air conditioning device with which a heat radiation efficiency can be improved without changing the height dimension of a heat radiation fin.

### Solution to Problem

To solve the above-described problem, a vehicular air conditioning device according to the present disclosure adopts the following means.

That is, the vehicular air conditioning device according to an aspect of the present disclosure includes: a casing including an air inlet and an air outlet, the casing being formed with a flow path communicating with the air inlet and the air outlet; a fan housed in the casing, the fan generating a flow of air from the air inlet to the air outlet through the flow path; a heat generation portion disposed outside the casing; and a heat radiation portion. The heat radiation portion includes a base being thermally connected to the heat generation portion and including an installation surface, and a plurality of fins having a plate-like shape. The plurality of fins are disposed in the flow path to extend along a flow direction of the air and stand from the installation surface in a direction orthogonal to the flow direction. The surfaces of the plurality of fins are provided with a plurality of ridges. The plurality of ridges are formed along the flow direction and provided along a standing direction of the plurality of fins.

### Advantageous Effects of Invention

According to the present disclosure, it is possible to improve the heat radiation efficiency without changing the height dimension of the heat radiation fin.

### Brief Description of Drawings

FIG. 1 is a front view of a vehicular air conditioning device according to an aspect of the present disclosure.
FIG. 2 is a perspective view illustrating the interior of a casing (the vicinity of a flow path).
FIG. 3 is an upper perspective view of a heat generation portion and a heat radiation portion.
FIG. 4 is a lower perspective view of the heat generation portion and the heat radiation portion.
FIG. 5 is a front view of the heat generation portion and the heat radiation portion.
FIG. 6 is an enlarged view of the heat radiation portion.
FIG. 7 is an enlarged view of a fin.
FIG. 8 is an enlarged view of the heat radiation portion.

### Description of Embodiments

A vehicular air conditioning device according to an embodiment of the present disclosure will be described below with reference to the accompanying drawings.

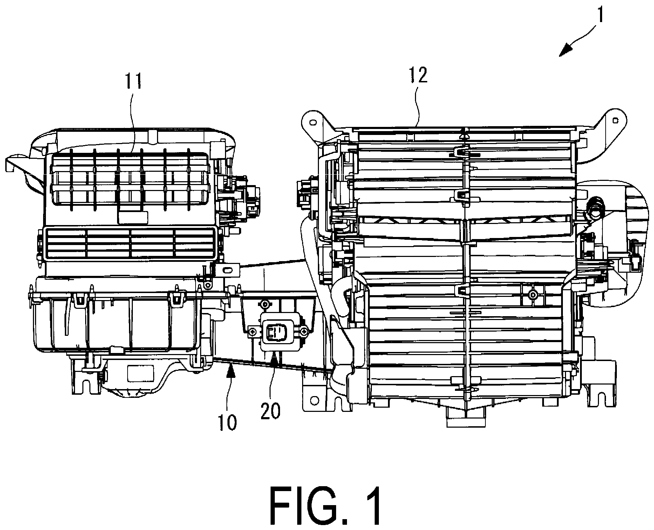

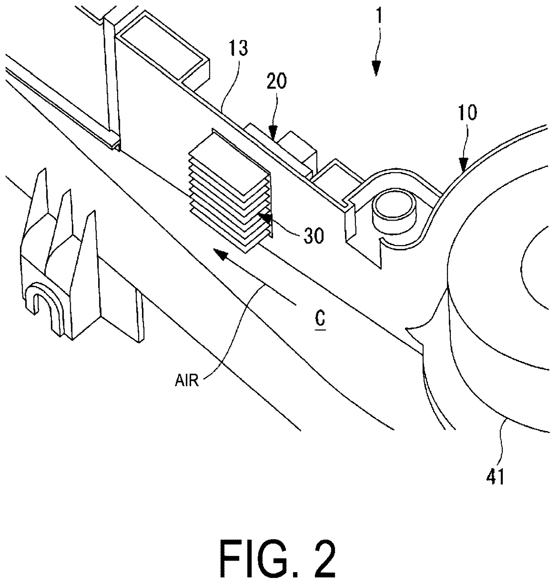

As illustrated in FIGS. 1 and 2, a vehicular air conditioning device 1 includes a casing 10 that accommodates devices such as a fan 41 and an evaporator (not illustrated).

The casing 10 includes an air inlet 11 and an air outlet 12.

The casing 10 defines a flow path C communicating with the air inlet 11 and the air outlet 12.

The air inlet 11 is an opening through which air is taken into the casing 10 from the outside of the casing 10.

The air outlet 12 is an opening through which the air heat-exchanged by the evaporator (not illustrated) is discharged to the outside of the casing 10.

The flow of air from the air inlet 11 to the air outlet 12 through the flow path C is generated by the fan 41.

The fan 41 is housed in the casing 10 on the air inlet 11 side.

The fan 41 is rotationally driven by a motor (not illustrated).

The rotation of the motor that drives the fan 41 is controlled by a power element (for example, a MOS-FET).

The power element is a semiconductor element for power control and generates heat when energized. For this reason, when the vehicular air conditioning device 1 is operated, the power element as a heat generation portion is cooled by a heat radiation portion 30.

As illustrated in FIG. 2, a unit 20 including therein the heat generation portion is attached to a wall portion 13 of the casing 10, the wall portion 13 defining the flow path C.

The unit 20 is disposed outside the wall portion 13 (outside the casing 10).

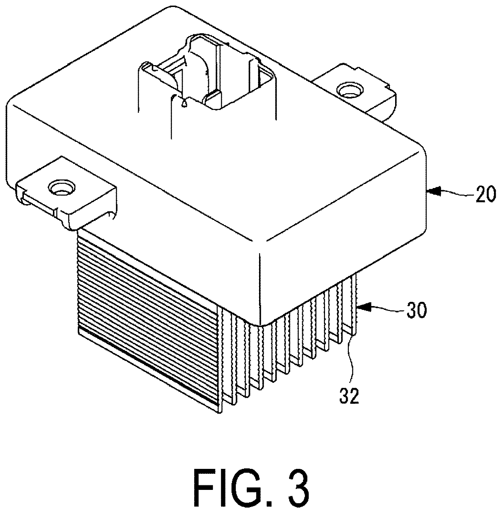

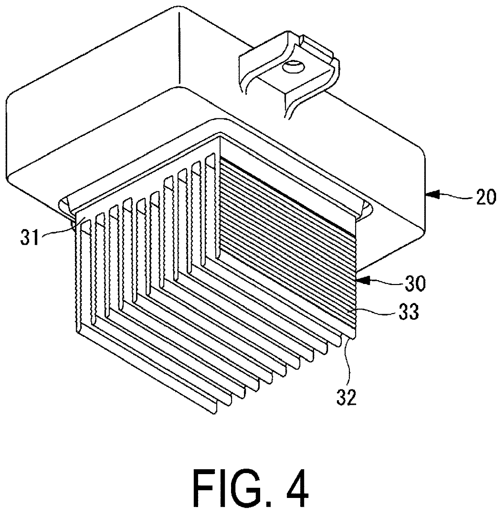

As illustrated in FIGS. 2 to 5, the heat radiation portion 30 includes a base 31 and a plurality of fins 32.

The heat radiation portion 30 is formed of a metal (for example, an aluminum alloy) having an excellent heat conductivity.

The base 31 is a portion in thermal contact with the heat generation portion (power element) in the heat radiation portion 30. This enables the heat generated by the heat generation portion to be transferred to the heat radiation portion 30.

The base 31 is formed with an installation surface 31a.

The installation surface 31a is a surface along the flow direction of air flowing through the flow path C.

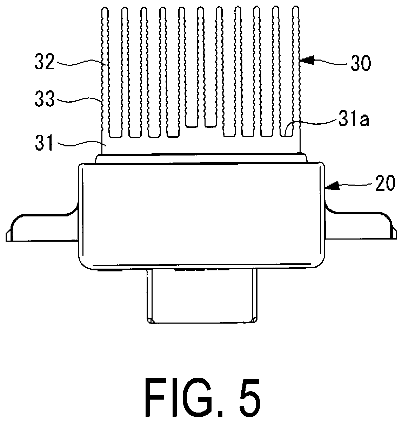

In a cross section (see FIG. 5) orthogonal to the flow direction of air, a central portion of the installation surface 31a in a width direction protrudes in a convex shape. Note that the protrusion of the central portion is not limited to having a step-like shape as illustrated in FIG. 5 and may have a mountain shape.

The plurality of fins 32 are provided at the installation surface 31a.

Each fin 32 is a thin plate-like part extending along the flow direction of air and standing from the installation surface 31a in a direction orthogonal to the flow direction of air.

As illustrated in FIG. 2, the installation surface 31a and the fins 32 are disposed in the flow path C (inside the casing 10).

With this configuration, the air flowing through the flow path C takes heat from the heat radiation portion 30, and consequently the heat generation portion is cooled.

To improve the heat radiation efficiency of the heat radiation portion 30 configured as described above, the present embodiment adopts the following configuration.

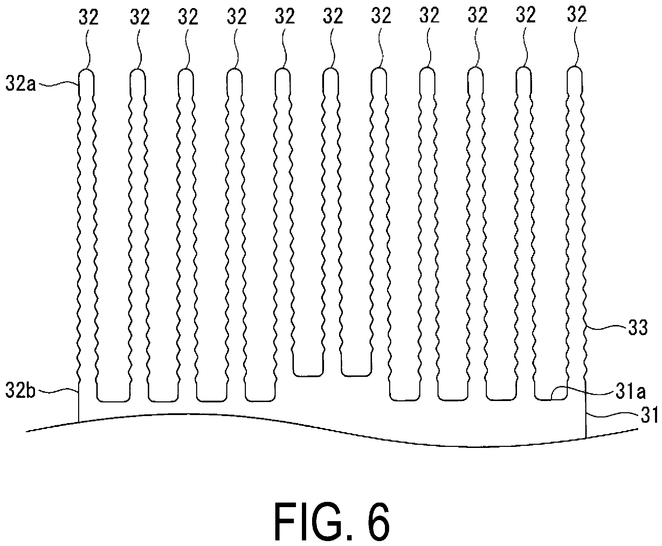

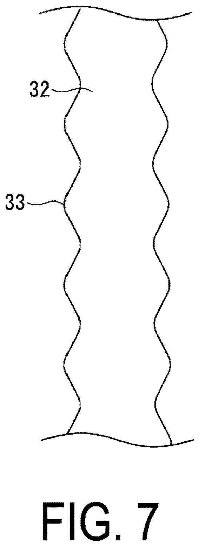

That is, as illustrated in FIGS. 6 and 7, a plurality of ridges 33 are formed at the side surfaces of the fins 32 which are located along the flow direction of air.

Each ridge 33 is an elongated protrusion extending along the flow direction of air to be parallel to the installation surface 31a.

Each ridge 33 is formed continuously and integrally along the flow direction of air. Further, the plurality of ridges 33 are provided over the standing direction of the fin 32 (the vertical direction in FIG. 6).

By providing the ridges 33, the surface area of the fins 32 can be increased, and the heat radiation efficiency at the heat radiation portion 30 can be improved.

In addition, it is possible to suppress the air flowing on the installation surface 31a from being separated from the installation surface 31a because the air flowing on the installation surface 31a is made less likely to move in the standing direction of the fins 32 by the presence of the ridges 33 and the flow velocity of the air is slightly reduced by a flow path resistance generated by the ridges 33. In particular, the separation from a rear half portion (a rear half portion in the flow direction of air) of the installation surface 31a can be suppressed.

### Ridge Arrangement Example 1

The ridges 33 may be formed over the entire region of the fins 32 in the height direction of the fins 32.

In that case, the surface area of the fins 32 can be increased by making the most of the height dimension (the dimension along the standing direction) of the fins 32.

### Ridge Arrangement Example 2

Alternatively, the ridges 33 may be omitted at a part of a leading end 32a side and a part of a base end 32b side of each fin 32.

As described above, since the ridges 33 are portions that can constitute a flow path resistance in view of the entire flow path C, a pressure loss caused by the fins 32 can be reduced by omitting the ridges 33 in partial regions in the standing direction.

### Ridge Arrangement Example 3

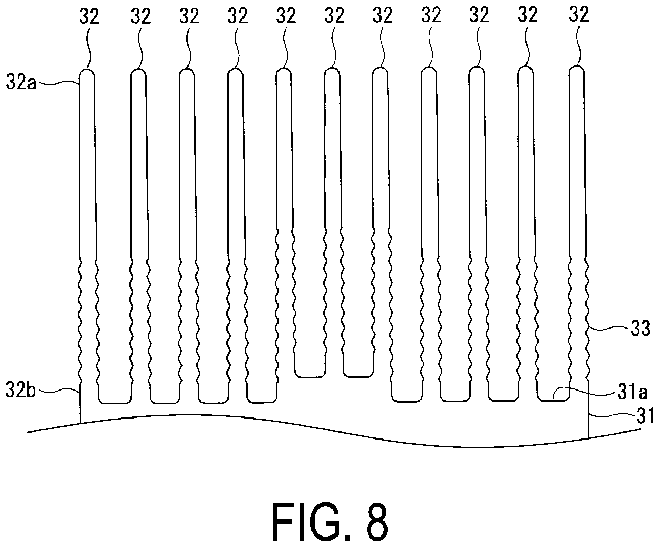

Alternatively, as illustrated in FIG. 8, the ridges 33 may be formed only at a half portion of each fin 32 on the base end 32b side in the standing direction of the fins 32.

In that case, it is possible to suppress the separation of air on the base end 32b side of the fins 32 and suppress the pressure loss due to the ridges 33 on the leading end 32a side.

The heat radiation portion 30 configured as described above is made by, for example, extrusion molding. Accordingly, the heat radiation portions 30 having the same cross-sectional shape can be mass-produced.

According to the present embodiment, the following effects are achieved.

Since the plurality of ridges 33 formed along the flow direction are provided on the surface of the fins 32 over the standing direction of the fins 32, the surface area of the fins 32 can be increased and the heat radiation efficiency of the heat radiation portion 30 can be improved.

In addition, it is possible to suppress the air flowing on the installation surface 31a from being separated from the installation surface 31a because the air flowing on the installation surface 31a is made less likely to move in the standing direction of the fins 32 by the presence of the ridges 33 and the flow velocity of the air is slightly reduced by a flow path resistance generated by the ridges 33.

Accordingly, the flow of air is maintained on the installation surface 31a (that is, there is no region where the flow velocity is 0 or where air flows backward), and thus a decrease in the heat radiation efficiency at the installation surface 31a and the fins 32 standing from the installation surface 31a can be suppressed.

When the ridges 33 are formed over the entire region of the fins 32 in the standing direction, the surface area of the fins 32 can be maximized.

When the ridges 33 are not formed at a part of the leading end 32a side and a part of the base end 32b side of each fin 32 in the standing direction of the fins 32, the pressure loss in the part of the leading end 32a side and the part of the base end 32b side can be suppressed. Accordingly, the pressure loss of the entire flow path C can be suppressed.

When the ridges 33 are formed only at a half portion of each fin 32 on the base end 32b side in the standing direction of the fins 32, it is possible to suppress the separation of air on the base end 32b side and suppress the pressure loss due to the ridges 33 on the leading end 32a side.

The present embodiment described above is understood as follows, for example.

That is, a vehicular air conditioning device according to an aspect of the present disclosure includes: a casing (10) including an air inlet (11) and an air outlet (12), the casing being formed with a flow path (C) communicating with the air inlet and the air outlet; a fan (41) housed in the casing, the fan generating a flow of air from the air inlet to the air outlet through the flow path; a heat generation portion disposed outside the casing; and a heat radiation portion (30). The heat radiation portion includes a base (31) being thermally connected to the heat generation portion and including an installation surface (31a), and a plurality of fins (32) having a plate-like shape. The plurality of fins are disposed in the flow path to extend along a flow direction of the air and stand from the installation surface in a direction orthogonal to the flow direction. The surfaces of the plurality of fins are provided with a plurality of ridges (33). The plurality of ridges are formed along the flow direction and provided along a standing direction of the plurality of fins.

The vehicular air conditioning device according to the present aspect includes the casing, the fan, the heat generation portion, and the heat radiation portion. The heat radiation portion is thermally connected to the heat generation portion and includes the base including the installation surface, and the plurality of fins having a plate-like shape. The plurality of fins are disposed in the flow path to extend along the flow direction of air and stand from the installation surface in the direction orthogonal to the flow direction. The surfaces of the plurality of fins are provided with the plurality of ridges. The plurality of ridges are formed along the flow direction and provided over the standing direction of the fins. Therefore, the surface area of the fins can be increased, and thus the heat radiation efficiency can be improved.

In addition, it is possible to suppress the air flowing on the installation surface from being separated from the installation surface because the air flowing on the installation surface is made less likely to move in the standing direction of the fins by the presence of the ridges and the flow velocity of the air is slightly reduced by a flow path resistance generated by the ridges. Accordingly, the flow of air is maintained on the installation surface, and thus a decrease in the heat radiation efficiency at the installation surface and the fins standing from the installation surface can be suppressed.

Here, the heat generation portion is, for example, a power element that controls the rotation of the fan.

In the vehicular air conditioning device according to an aspect of the present disclosure, the plurality of ridges are formed over the entire region in the standing direction of the fins.

In the vehicular air conditioning device according to the present aspect, since the plurality of ridges are formed over the entire region in the standing direction of the fins, the surface area of the fins can be maximized.

In the vehicular air conditioning device according to an aspect of the present disclosure, the plurality of ridges are not formed at a part of the leading end side and a part of the base end side of each fin in the standing direction of the fins.

Since the plurality of ridges are not formed at a part of the leading end side and a part of the base end side of each fin in the standing direction of the fins, it is possible to suppress a pressure loss in the part of the leading end side and the part of the base end side. Accordingly, the pressure loss of the entire flow path can be suppressed.

In the vehicular air conditioning device according to an aspect of the present disclosure, the plurality of ridges are formed only at a half portion of each fin on the base end side in the standing direction of the fins.

In the vehicular air conditioning device according to the present aspect, since the plurality of ridges are formed only at a half portion of each fin on the base end side in the standing direction of the fins, it is possible to suppress the separation of air on the base end side and suppress the pressure loss due to the ridges on the leading end side.

In the vehicular air conditioning device according to an aspect of the present disclosure, an extending direction of the plurality of ridges is parallel to the installation surface.

In the vehicular air conditioning device according to the present aspect, since the extending direction of the plurality of ridges is parallel to the installation surface, the heat radiation portion can be made by extrusion molding.

### Reference Signs List

1 Vehicular air conditioning device
10 Casing
11 Air inlet
12 Air outlet
13 Wall portion
20 Unit (unit including a heat generation portion)
30 Heat radiation portion
31 Base
31a Installation surface
32 Fin
32a Leading end
32b Base end
33 Ridge
41 Fan

## Claims

1. A vehicular air conditioning device comprising:
a casing including an air inlet and an air outlet, the casing being formed with a flow path communicating with the air inlet and the air outlet;
a fan housed in the casing, the fan generating a flow of air from the air inlet to the air outlet through the flow path;
a heat generation portion disposed outside the casing; and
a heat radiation portion,
the heat radiation portion including
a base being thermally connected to the heat generation portion and including an installation surface, and
a plurality of fins having a plate-like shape, the plurality of fins being disposed in the flow path to extend along a flow direction of the air and stand from the installation surface in a direction orthogonal to the flow direction,
wherein surfaces of the plurality of fins are provided with a plurality of ridges, the plurality of ridges being formed along the flow direction and provided along a standing direction of the fins.

2. The vehicular air conditioning device according to claim 1, wherein the plurality of ridges are formed over an entire region of the fins in the standing direction of the fins.

3. The vehicular air conditioning device according to claim 1, wherein the plurality of ridges are not formed at a part of a leading end side and a part of a base end side of each of the fins in the standing direction of the fins.

4. The vehicular air conditioning device according to claim 1, wherein the plurality of ridges are formed only at a half portion of each of the fins on the base end side in the standing direction of the fins.

5. The vehicular air conditioning device according to any one of claims 1 to 4, wherein an extending direction of the plurality of ridges is parallel to the installation surface.
